# EUROPÄISCHE PATENTSCHRIFT

(11) **EP 2 067 177 B1**
(45) Veröffentlichungstag und Bekanntmachung des Hinweises auf die Patenterteilung: **19.04.2017**
(21) Anmeldenummer: 07801345.5
(22) Anmeldetag: 17.09.2007
(51) Int. Cl.: H01L 33/00

(54) **OPTOELEKTRONISCHES BAUELEMENT**
OPTOELECTRONIC COMPONENT
COMPOSANT OPTO-ÉLECTRONIQUE

(30) Priorität: 29.09.2006 DE 102006046277
(43) Veröffentlichungstag der Anmeldung: 10.06.2009
(73) Patentinhaber: OSRAM Opto Semiconductors GmbH, 93055 Regensburg (DE)
(72) Erfinder: GRÖTSCH, Stefan, 93077 Lengfeld-Bad Abbach (DE); LINDER, Norbert, 93138 Lappersdorf (DE)
(74) Vertreter: Epping - Hermann - Fischer
(86) Internationale Anmeldenummer: PCT/DE2007/001679
(87) Internationale Veröffentlichungsnummer: WO 2008/040298

(56) Entgegenhaltungen:
- EP-A- 1 657 758
- WO-A-2006/035388
- US-A1- 2004 150 997
- US-A1- 2004 218 390
- US-A1- 2006 091 412
- US-A1- 2006 164 838

## Beschreibung

Die vorliegende Erfindung betrifft ein optoelektronisches Bauelement mit mindestens einem Halbleiterkörper, der einen aktiven Bereich zur Erzeugung elektromagnetischer Strahlung aufweist. Ein derartiges Bauelement kann beispielsweise als Leuchtdiode (LED) ausgeführt sein. Herkömmliche Leuchtdioden emittieren in der Regel inkohärente unpolarisierte Strahlung. US 2006/0091412 A offenbart eine Lichtquelle mit einer LED, die polarisiertes Licht emittiert. Dabei ist über der LED ein Polarisationsfilter angeordnet, das Licht einer bestimmten Polarisation transmittiert und Licht mit einer anderen Polarisation zurück in die LED reflektiert.

Es ist Aufgabe der vorliegenden Erfindung, die von einem Bauelement der eingangs genannten Art, beispielsweise einer LED, emittierte Strahlung hinsichtlich einer vorgegebenen Strahlungseigenschaft zu selektieren. Insbesondere soll ein möglichst hoher Anteil von Strahlung der vorgegebenen Strahlungseigenschaft erzeugt werden.

Diese Aufgabe wird durch ein optoelektronisches Bauelement gemäß Patentanspruch 1 gelöst. Vorteilhafte Weiterbildungen der Erfindung sind Gegenstand der abhängigen Ansprüche. Gegenstände, die in der vorliegenden Beschreibung genannt sind aber nicht unter den Umfang der Patentansprüche fallen, sind lediglich Gegenstände dieser Offenbarung aber nicht Teil der Erfindung.

Erfindungsgemäß ist ein optoelektronisches Bauelement mit mindestens einem Halbleiterkörper, der einen aktiven Bereich zur Erzeugung elektromagnetischer Strahlung umfasst, vorgesehen, wobei das Bauelement ein Gehäuse mit einem dem aktiven Bereich nachgeordneten Filterelement aufweist, welches einen Primärstrahlungsanteil mit einer vorgegebenen Primärstrahlungseigenschaft selektiv transmittiert.

Die Primärstrahlungseigenschaft kann sich beispielsweise auf die Polarisation, die Wellenlänge oder/und die Richtung des Primärstrahlungsanteils beziehen.

Bei einer vorteilhaften Ausgestaltung des optoelektronischen Bauelements wird von dem Filterelement weiterhin ein Sekundärstrahlungsanteil mit einer von der Primärstrahlungseigenschaft verschiedenen Sekundärstrahlungseigenschaft reflektiert. Vorzugsweise erfolgt diese Reflexion des Sekundärstrahlungsanteils derart, dass der Sekundärstrahlungsanteil in den Halbleiterkörper zurückreflektiert wird und dort einem Ablenkprozess und/oder einem Absorptions- und Reemissionsprozess unterliegt, und die abgelenkte beziehungsweise reemittierte Strahlung auf das Filterelement erneut auftrifft. Mit Vorteil wird durch die genannten Prozesse der Strahlungsanteil mit der vorgegebenen Primärstrahlungseigenschaft und damit der von dem Filterelement insgesamt transmittierte Primärstrahlungsanteil erhöht.

Vorzugsweise ist die Primärstrahlungseigenschaft komplementär zur Sekundärstrahlungseigenschaft. Dies bedeutet, dass die Primärstrahlungseigenschaft und die Sekundärstrahlungseigenschaft die gleiche physikalische Eigenschaft, etwa die Polarisation, betreffen und sich gegenseitig ausschließen, wie dies beispielsweise bei zueinander orthogonalen Polarisationsrichtungen bei linear polarisierter Strahlung der Fall ist.

Das Filterelement kann bei dem optoelektronischen Bauelement als als Polarisationsfilter ausgeführt sein, so dass der Primärstrahlungsanteil mit einer vorgegebenen Polarisationseigenschaft transmittiert und der Sekundärstrahlungsanteil mit einer hiervon abweichenden Polarisation, etwa einer komplementären Polarisation, absorbiert oder bevorzugt reflektiert wird.

Bei einer weiteren Variante des optoelektronischen Bauelements ist das Filterelement als Richtungsfilter ausgeführt, so dass der Primärstrahlungsanteil mit einer vorgegebenen Abstrahlrichtung von dem Filterelement transmittiert wird, und der Sekundärstrahlungsanteil mit einer von der vorgegebenen Abstrahlrichtung abweichenden Propagationsrichtung in dem Filterelement absorbiert oder reflektiert wird.

Weitergehend können die beispielhaft genannten Varianten der Filter bei dem optoelektronischen Bauelement auch kombiniert werden. So kann etwa durch Kombination eines Richtungsfilters mit einem Polarisationsfilter bewirkt werden, dass der transmittierte Primärstrahlungsanteil eine vorgegebene Propagationsrichtung und eine vorgegebene Polarisation aufweist.

Bei allen oben genannten Filtervarianten wird bevorzugt der Sekundärstrahlungsanteil in den strahlungsemittierenden Halbleiterkörper zurückreflektiert und unterliegt dort einem Ablenk- oder einem Absorptions- und Reemissionsprozess, so dass vorteilhaft der ausgekoppelte Primärstrahlungsanteil insgesamt gesteigert werden kann.

Bei der Ausführungsvariante des Filterelements als richtungsselektives Filter kann das Filterelement Strukturelemente aufweisen, die eine Filterung der emittierten Strahlung hinsichtlich der Abstrahlrichtung bewirken. Diese Strukturelemente können beispielsweise kegelartig, pyramidenartig oder prismenartig ausgebildet und weitergehend in Form eines zweidimensionalen Gitters angeordnet sein.

Vorzugsweise ist bei dem optoelektronischen Bauelement der strahlungsemittierende Halbleiterkörper als Dünnfilm-Halbleiterkörper ausgeführt.

Ein Dünnfilm-Halbleiterkörper zeichnet sich insbesondere durch mindestens eines der folgenden charakteristischen Merkmale aus:
- an einer zu einem Trägerelement hin gewandten ersten Hauptfläche einer strahlungserzeugenden Epitaxieschichtenfolge ist eine Reflexionsschicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20 µm oder weniger, insbesondere im Bereich von 10 µm auf; und
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip eines Dünnschicht-Leuchtdiodenchips ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug aufgenommen wird.

Ein Dünnfilm-Leuchtdioden-Chip ist in guter Näherung ein Lambert'scher Oberflächenstrahler und eignet sich insbesondere für Scheinwerfer- und Projektionsanwendungen.

Vorzugsweise ist bei dem optoelektronischen Bauelement eine Reflexionsschicht auf einer dem Filterelement gegenüber liegenden Seite der aktiven Schichtenfolge angeordnet. Die Reflexionsschicht kann beispielsweise ein metallisches Material und/oder ein transparentes leitfähiges Oxid, etwa ein Metalloxid enthalten. Bevorzugt ist die Reflexionsschicht außerhalb des Halbleiterkörpers angeordnet.

Der Halbleiterkörper ist vorzugsweise auf einem Trägerelement befestigt. Im Falle der oben genannten Reflexionsschicht ist diese zwischen dem Halbleiterkörper und dem Trägerelement positioniert.

Der Halbleiterkörper, vorzugsweise der aktive Bereich, kann ein auf Phosphid basierendes Verbindungshalbleitermaterial enthalten. Das Verbindungshalbleitermaterial weist insbesondere die Zusammensetzung AlₙGaₘIn₁₋ₙ₋ₘP, wobei 0 ≤ n ≤ 1, 0 ≤ m ≤ 1 und n+m ≤ 1 ist, auf.

Alternativ kann der Halbleiterkörper, vorzugsweise der aktive Bereich, ein auf Arsenid basierendes Verbindungshalbleitermaterial enthalten. Das Verbindungshalbleitermaterial weist insbesondere die Zusammensetzung AlₙGaₘIn₁₋ₙ₋ₘAs, wobei 0 ≤ n ≤ 1, 0 ≤ m ≤ 1 und n+m ≤ 1 ist, auf.

Entsprechend einer weiteren Möglichkeit kann der Halbleiterkörper, vorzugsweise der aktive Bereich, ein auf Nitrid basierendes Verbindungshalbleitermaterial enthalten. Das Verbindungshalbleitermaterial weist insbesondere die Zusammensetzung AlₙGaₘIn₁₋ₙ₋ₘN, wobei 0 ≤ n ≤ 1, 0 ≤ m ≤ 1 und n+m ≤ 1 ist, auf.

Alternativ kann der Halbleiterkörper ein auf Zinkoxid basierendes Halbleitermaterial enthalten, besonders bevorzugt enthält der Halbleiterkörper MgZnCdO.

Das Filterelement enthält vorzugsweise ein Glasmaterial.

Alternativ kann das Filterelement Saphir, transparente Kristalle oder Quarz enthalten.

Entsprechend einer weiteren Möglichkeit kann das Filterelement transparente Keramiken enthalten, beispielsweise Al₂O₃.

Alternativ kann das Filterelement SiC oder Diamant enthalten.

Beim optoelektronischen Bauelement ist das Filterelement von dem Halbleiterkörper beabstandet angeordnet. Bevorzugt ist der Abstand zwischen Filterelement und Halbleiterkörper kleiner als 0,5 mm, besonders bevorzugt kleiner als 0,1 mm. Mit Vorteil ist der Abstand zwischen Filterelement und Halbleiterkörper größer als 0 µm und kleiner als oder gleich 10 µm.

Bei einer weiteren Ausführungsform des optoelektronischen Bauelements ist zwischen dem Halbleiterkörper und dem Filterelement ein Konversionselement angeordnet, das die von dem Halbleiterkörper emittierte Strahlung in Strahlung anderer Wellenlänge umwandelt. Auf diese Art und Weise kann mischfarbiges, insbesondere weißes Licht erzeugt werden. Auch eine Farbverschiebung der von dem Halbleiterkörper erzeugten Strahlung, beispielsweise von ultraviolettem Licht in grünes Licht, ist möglich.

Je nach Art und Ausgestaltung des Filterelements lässt sich das Spektrum, die Richtungsverteilung oder/und die Polarisation der von dem optoelektronischen Element emittierten und als Nutzstrahlungsanteil transmittierten Strahlung in vorgegebener Weise modifizieren.

Weitere Merkmale, Vorzüge und Zweckmäßigkeiten des optoelektronischen Bauelements ergeben sich aus den nachfolgend beschriebenen sieben Ausführungsbeispielen in Verbindung mit den Figuren 1 bis 7.

Es zeigen:
- Figur 1: eine schematische Schnittdarstellung eines ersten Ausführungsbeispiels eines erfindungsgemäßen optoelektronischen Bauelements,
- Figur 2: eine schematische Schnittansicht eines zweiten Ausführungsbeispiels eines erfindungsgemäßen optoelektronischen Bauelements,
- Figur 3: eine schematische Schnittansicht eines dritten Ausführungsbeispiels eines erfindungsgemäßen optoelektronischen Bauelements,
- Figur 4: eine schematische Schnittdarstellung eines vierten Ausführungsbeispiels eines erfindungsgemäßen optoelektronischen Bauelements,
- Figur 5: eine schematische Schnittdarstellung eines fünften Ausführungsbeispiels eines erfindungsgemäßen optoelektronischen Bauelements,
- Figur 6: eine schematische, perspektivische Ansicht eines sechsten Ausführungsbeispiels eines erfindungsgemäßen optoelektronischen Bauelements, und
- Figur 7: eine schematische, perspektivische Detailansicht eines siebten Ausführungsbeispiels eines erfindungsgemäßen optoelektronischen Bauelements.

Gleiche oder gleichwirkende Elemente sind in den Figuren mit denselben Bezugszeichen versehen.

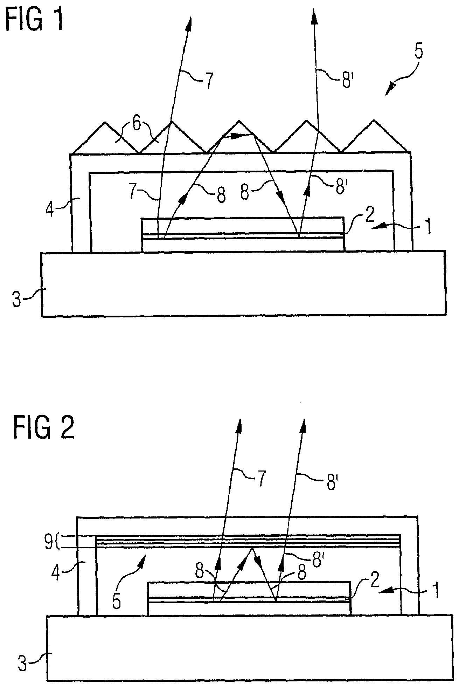

Das in Figur 1 dargestellte Ausführungsbeispiel eines optoelektronischen Bauelements weist einen Halbleiterkörper 1 mit einem aktiven Bereich 2 zur Erzeugung elektromagnetischer Strahlung auf, der auf einem Trägerelement 3 aufgebracht ist. Das Trägerelement 3 bildet zusammen mit einem kappenartigen Gehäusedeckel 4 das Gehäuse des optoelektronischen Bauelements.

Abstrahlungsseitig ist der Gehäusedeckel 4 als Filterelement 5 ausgebildet. Bei dem Ausführungsbeispiel gemäß Figur 1 bildet dieses Filterelement ein richtungsselektives Filter. Hierzu weist das Filterelement 5 eine Mehrzahl von Strukturelementen 6 auf, die vorliegend pyramidenförmig ausgeführt und weitergehend in laterale Richtung gitterartig angeordnet sein können.

Das Filterelement ist so beschaffen, dass ein Primärstrahlungsanteil 7 mit einer vorgegebenen Abstrahlrichtung transmittiert wird, während ein Sekundärstrahlungsanteil 8 mit einer von der vorgegebenen Abstrahlungsrichtung abweichenden Strahlungsrichtung von den Strukturelementen 6 in Richtung des Halbleiterkörpers 1 zurückreflektiert wird.

In dem Halbleiterkörper 1 unterliegt dieser zurückreflektierte Sekundärstrahlungsanteil 8 innerhalb des aktiven Bereichs einem Absorptions- und nachfolgenden Reemissionsprozess. Da der Reemissionsprozess näherungsweise isotrop erfolgt oder zumindest keine ausgeprägte Vorzugsrichtung aufweist, besteht eine gewisse Wahrscheinlichkeit, dass der so reemittierte Strahlungsanteil 8' die vorgegebene Abstrahlcharakteristik aufweist und nachfolgend von dem Filterelement 5 transmittiert wird. Andernfalls kann dieser Strahlungsanteil erneut in Richtung des Halbleiterkörpers zurückreflektiert und einem weiteren Absorptions- und Reemissionsprozess oder Ablenkprozess zugeführt werden.

Das in Figur 2 dargestellte Ausführungsbeispiel eines optoelektronischen Bauelements entspricht bezüglich Halbleiterkörper 1, strahlungsemittierendem Bereich 2, Trägerelement 3 und Gehäusedeckel 4 im Wesentlichen dem in Figur 1 dargestellten Ausführungsbeispiel.

Im Unterschied hierzu ist das Filterelement 5 als dielektrisches Winkelfilter ausgeführt. Mittels eines dielektrischen Schichtstapels 9 wird somit ein Primärstrahlungsanteil 7 mit einer vorgegebenen Abstrahlrichtung selektiert. Sekundärstrahlungsanteile 8 mit einer hiervon abweichenden Abstrahlrichtung werden in Richtung des Halbleiterkörpers zurückreflektiert und gegebenenfalls reemittiert.

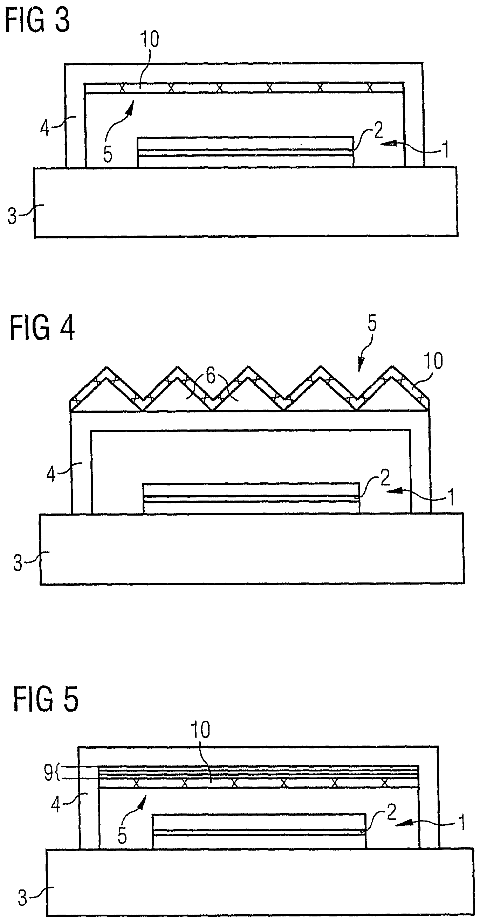

In Figur 3 ist ein weiteres Ausführungsbeispiel eines optoelektronischen Bauelements gezeigt.
Dieses Ausführungsbeispiel entspricht bezüglich Halbleiterkörper 1, strahlungsemittierendem Bereich 2, Trägerelement 3 und Gehäusedeckel 4 sowie dem Strahlverlauf im Wesentlichen dem in Figur 1 beziehungsweise Figur 2 dargestellten Ausführungsbeispiel.

Im Unterschied zu den in Figur 1 und 2 dargestellten Ausführungsbeispielen ist das Filterelement 5 als Polarisationsfilter ausgeführt, das einen Primärstrahlungsanteil mit einer vorgegebenen Polarisation transmittiert, während ein Sekundärstrahlungsanteil mit einer hiervon abweichender Polarisation reflektiert und gegebenenfalls nachfolgend von dem Halbleiterkörper reemittiert wird.

Das Polarisationsfilter kann als Filterschicht 10 auf der Innenseite oder Aussenseite (nicht dargestellt) des Gehäusedeckels 4 aufgebracht sein. Weitergehend kann das Filterelement als Drahtgitterpolarisator (Wire-Grid-Polarizer) ausgeführt sein.

Das in Figur 4 dargestellte Ausführungsbeispiel eines optoelektronischen Bauelements entspricht bezüglich Halbleiterkörper 1, strahlungsemittierendem Bereich 2, Trägerelement 3, Gehäusedeckel 4 und richtungsselektivem Filter mit Strukturelementen 6 sowie dem Strahlverlauf im Wesentlichen dem in Figur 1 dargestellten Ausführungsbeispielen.

Zusätzlich ist abstrahlungsseitig auf die Strukturelemente ein Polarisationsfilter 10 aufgebracht, so dass bei diesem Ausführungsbeispiel sowohl Abstrahlrichtung als auch Polarisation des transmittierten Primärstrahlungsanteils selektiert werden. Das Polarisationsfilter kann beispielsweise als Drahtgitterpolarisator ausgeführt sein.

Das in Figur 5 dargestellte Ausführungsbeispiel eines optoelektronischen Bauelements entspricht bezüglich Halbleiterkörper 1, strahlungsemittierendem Bereich 2, Trägerelement 3, Gehäusedeckel 4 und dielektrischem Winkelfilter mit einem dielektrischen Schichtstapel 9 sowie dem Strahlverlauf im Wesentlichen dem in Figur 2 dargestellten Ausführungsbeispiel.

Zusätzlich zu dem Winkelfilter 9 weist das Filterelement 5 ein Polarisationsfilter 10, etwa ein Drahtgitterpolarisator, auf. Entsprechend kann hierbei die Polarisation und die Abstrahlcharakteristik des transmittierten Primärstrahlungsanteils selektiert werden.

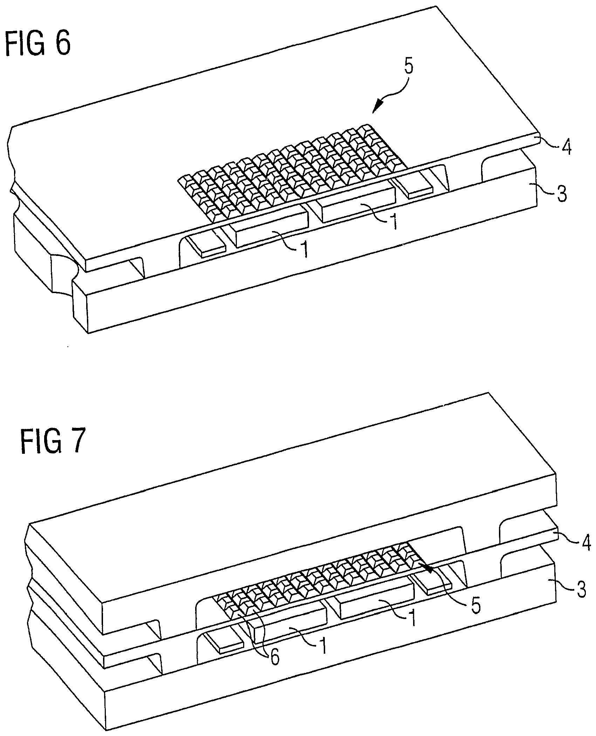

In Figur 6 ist eine perspektivische Detailansicht eines weiteren Ausführungsbeispiels gezeigt.

Auf einem gemeinsamen Trägerelement 3, etwa einem Keramiksubstrat, ist eine Mehrzahl von Halbleiterkörpern 1, vorzugsweise in Form von Dünnfilm-Halbleiterkörpern, angeordnet. Die Dünnfilm-Halbleiterkörper sind substratlos ausgeführt, das heißt, sie weisen kein Epitaxie-Aufwachssubstrat auf. Weitergehend ist zwischen den aktiven Bereichen und dem Trägerelement 3, vorzugsweise zwischen den Halbleiterkörpern 1 und dem Trägerelement 3, jeweils eine Reflexionsschicht ausgebildet.

Oberseitig werden die Halbleiterkörper 1 von einem kappenförmigen Gehäusedeckel 4 überspannt. In den Gehäusedeckel 4 ist ein Filterelement 5 integriert, das wie dargestellt als richtungsselektives Filter mit einer Mehrzahl von Strukturelementen ausgebildet sein kann. Die Strukturelemente sind pyramidenstumpfartig geformt und in lateraler Richtung gitterartig angeordnet.

In Figur 7 ist eine perspektivische Detailansicht eines weiteren Ausführungsbeispiels gezeigt.

Ähnlich wie in Figur 6 ist auf einem gemeinsamen Trägerelement 3, etwa einem Keramiksubstrat, eine Mehrzahl von Halbleiterkörpern 1, vorzugsweise in Form von Dünnfilm-Halbleiterkörpern, angeordnet. Die Dünnfilm-Halbleiterkörper sind substratlös ausgeführt. Weitergehend ist zwischen den aktiven Bereichen und dem Trägerelement 3, vorzugsweise zwischen den Halbleiterkörpern 1 und dem Trägerelement 3, jeweils eine Reflexionsschicht ausgebildet.

Oberseitig werden die Halbleiterkörper 1 von einem ersten kappenförmigen Gehäusedeckel 4 überspannt. In den Gehäusedeckel 4 ist ein Filterelement 5 integriert, das wie dargestellt als richtungsselektives Filter mit einer Mehrzahl von Strukturelementen ausgebildet sein kann. Die Strukturelemente sind pyramidenstumpfartig geformt und in lateraler Richtung gitterartig angeordnet.

Ein zweiter Gehäusedeckel 11 ist dem ersten Gehäusedeckel 4 in Abstrahlungsrichtung nachgeordnet. Dieser zweite Gehäusedeckel kann reine Schutzwirkung gegen Umwelteinflüsse haben und optisch inaktiv sein. Weitergehend kann der zweite Gehäusedeckel mit einem weiteren Filterelement (nicht dargestellt), etwa einem Polarisationsfilter versehen sein.

Das Filterelement kann bei der Erfindung sowohl in das Gehäuse, etwa dem Gehäusedeckel, integriert als auch auf das Gehäuse als separates Element aufgebracht sein. Im letztgenannten Fall ist das Filterelement bevorzugt als Filterfolie ausgeführt. Hierfür können auch BEF-Folien (Brightness Enhancement Film) oder DBEF-Folien (Dual Brightness Enhancement Film) mit einer Prismenstruktur beziehungsweise mit Reflexionspolarisatoren verwendet werden. Derartige Folien werden auch als Vikuiti-Folien (Hersteller: 3M) bezeichnet.

## Patentansprüche

1. Optoelektronisches Bauelement mit mindestens einem Halbleiterkörper (1), der einen aktiven Bereich (2) zur Erzeugung elektromagnetischer Strahlung aufweist, und einem Gehäuse (4) mit einem dem aktiven Bereich (2) in Abstrahlrichtung nachgeordneten Filterelement (5), das einen Primärstrahlungsanteil (7) mit einer vorgegebenen Primärstrahlungseigenschaft selektiv transmittiert, wobei
- ein Sekundärstrahlungsanteil (8) mit einer von der Primärstrahlungseigenschaft verschiedenen Sekundärstrahlungseigenschaft von dem Filterelement (5) reflektiert wird, wobei sowohl die Primärstrahlungseigenschaft als auch die Sekundärstrahlungseigenschaft die Richtung und/oder die Polarisation des Strahlungsanteils (7) sind,
- das Filterelement (5) den Sekundärstrahlungsanteil (8) in den Halbleiterkörper (1) zurückreflektiert,
- der Sekundärstrahlungsanteil (8) in dem Halbleiterkörper (1) einem Ablenkprozess oder einem Absorptions- und Reemissionsprozess unterliegt,
- die ablenkte oder reemittierte Strahlung (8') auf das Filterelement (5) auftrifft
- auf einer dem Filterelement (5) gegenüber liegenden Seite des aktiven Bereichs eine Reflexionsschicht angeordnet ist und wobei das Filterelement (5) von dem Halbleiterkörper (1) beabstandet angeordnet ist und der Abstand zwischen Filterelement (5) und Halbleiterkörper (1) größer als 0 µm und kleiner als 0,1 mm ist.

2. Optoelektronisches Bauelement nach dem vorhergehenden Anspruch,
wobei das Filterelement (5) ein Polarisationsfilter (10) oder ein Richtungsfilter ist.

3. Optoelektronisches Bauelement nach einem der vorhergehenden Ansprüche,
wobei das Filterelement (5) ein Richtungsfilter ist und eine Mehrzahl von Strukturelementen (6) aufweist, die kegelartig, pyramidenartig, pyramidenstumpfartig oder prismenartig ausgebildet und entsprechend einem zweidimensionalen Gitter angeordnet sind.

4. Optoelektronisches Bauelement nach einem der Ansprüche 1 bis 2,
wobei das Filterelement (5) ein Richtungsfilter ist und einen dielektrischen Schichtstapel (9) aufweist.

5. Optoelektronisches Bauelement nach einem der vorhergehenden Ansprüche,
wobei das Filterelement (5) ein Glasmaterial enthält.

6. Optoelektronisches Bauelement nach einem der vorhergehenden Ansprüche,
wobei das Filterelement (5) in oder an dem Gehäuse (4) angeordnet oder als Deckel des Gehäuses (4) ausgeführt ist.

7. Optoelektronisches Bauelement nach einem der vorhergehenden Ansprüche,
wobei der Abstand zwischen Filterelement (5) und Halbleiterkörper (1) größer als 0 µm und kleiner als oder gleich 10 µm ist.

8. Optoelektronisches Bauelement nach einem der vorhergehenden Ansprüche,
wobei zwischen dem aktiven Bereich (2) und dem Filterelement (5) ein Konversionselement angeordnet ist, das von dem aktiven Bereich (2) erzeugte Strahlung in Strahlung anderer Wellenlänge umwandelt.

9. Optoelektronisches Bauelement nach einem der vorhergehenden Ansprüche,
wobei das Bauelement eine Mehrzahl von Halbleiterkörpern (1) mit jeweils einem aktiven Bereich (2) zur Erzeugung von elektromagnetischer Strahlung aufweist, die auf einem gemeinsamen Trägerelement angeordnet sind.

## Claims

1. An optoelectronic device having at least one semiconductor body (1), which comprises an active region (2) for producing electromagnetic radiation, and having a housing (4) comprising a filter element (5), which is arranged after the active region (2) in the emission direction and selectively transmits a primary radiation component (7) having a predetermined primary-radiation property, wherein
- a secondary radiation component (8) having a secondary-radiation property that differs from the primary-radiation property is reflected by the filter element (5), wherein both the primary-radiation property and the secondary-radiation property are the direction and/or the polarization of the radiation component (7),
- the filter element (5) reflects the secondary radiation component (8) back into the semiconductor body (1),
- the secondary radiation component (8) is subject to a deflection process or an absorption and re-emission process in the semiconductor body (1),
- the deflected or re-emitted radiation (8') impinges on the filter element (5),
- a reflection layer is arranged on an opposite side of the active region from the filter element (5),
and wherein the filter element (5) is spaced apart from the semiconductor body (1), and the distance between filter element (5) and semiconductor body (1) is greater than 0 µm and less than 0.1 mm.

2. The optoelectronic device as claimed in the preceding claim,
wherein the filter element (5) is a polarization filter (10) or a directional filter.

3. The optoelectronic device as claimed in any of the preceding claims,
wherein the filter element (5) is a directional filter and comprises a plurality of structural elements (6), which are designed in the shape of cones, pyramids, truncated pyramids or prisms and are arranged in accordance with a two-dimensional grid.

4. The optoelectronic device as claimed in either claim 1 or claim 2,
wherein the filter element (5) is a directional filter and comprises a dielectric layer stack (9).

5. The optoelectronic device as claimed in any of the preceding claims,
wherein the filter element (5) contains a glass material.

6. The optoelectronic device as claimed in any of the preceding claims,
wherein the filter element (5) is arranged in or on the housing (4) or is embodied as a cover of the housing (4).

7. The optoelectronic device as claimed in any of the preceding claims,
wherein the distance between filter element (5) and semiconductor body (1) is greater than 0 µm and less than or equal to 10 µm.

8. The optoelectronic device as claimed in any of the preceding claims,
wherein a conversion element, which converts radiation produced by the active region (2) into radiation of a different wavelength, is arranged between the active region (2) and the filter element (5).

9. The optoelectronic device as claimed in any of the preceding claims,
wherein the device comprises a plurality of semiconductor bodies (1), which each comprise an active region (2) for producing electromagnetic radiation and are arranged on a common substrate element.

## Revendications

1. Composant optoélectronique comprenant au moins un corps à semi-conducteur (1) qui présente une zone active (2) destinée à générer un rayonnement électromagnétique, et comprenant un boîtier (4) muni d'un élément filtrant (5) disposé en aval de la zone active (2), en direction de rayonnement, lequel élément filtrant transmet sélectivement une fraction de rayonnement primaire (7) ayant une caractéristique de rayonnement primaire prédéfinie,
- une fraction de rayonnement secondaire (8) ayant une caractéristique de rayonnement secondaire différente de la caractéristique de rayonnement primaire étant réfléchie par l'élément filtrant (5), aussi bien la caractéristique de rayonnement primaire que la caractéristique de rayonnement secondaire étant la direction et/ou la polarisation de la fraction de rayonnement (7),
- l'élément filtrant (5) réfléchissant en retour la fraction de rayonnement secondaire(8) dans le corps à semi-conducteur (1),
- la fraction de rayonnement secondaire (8) dans le corps à semi-conducteur (1) étant soumise à un processus de déviation ou à un processus d'absorption et de réémission,
- le rayonnement (8') dévié ou réémis arrivant sur l'élément filtrant (5),
- une couche de réflexion étant disposée sur un côté de la zone active, situé à l'opposé de l'élément filtrant (5), et l'élément filtrant (5) étant disposé à écart du corps à semi-conducteur (1), et l'écart entre l'élément filtrant (5) et le corps à semi-conducteur (1) étant supérieur à 0 µm et inférieur à 0,1 mm.

2. Composant opto-électronique selon la revendication précédente,
l'élément filtrant (5) étant un filtre polariseur (10) ou un filtre directionnel.

3. Composant opto-électronique selon l'une quelconque des revendications précédentes,
l'élément filtrant (5) étant un filtre directionnel et présentant une pluralité d'éléments structurels (6) qui sont réalisés en forme de cône, de pyramide, de pyramide tronquée ou de prisme et sont disposés de manière correspondant à une grille bidimensionnelle.

4. Composant opto-électronique selon l'une quelconque des revendications 1 à 2,
l'élément filtrant (5) étant un filtre directionnel et présentant un empilement de couches (9) diélectrique.

5. Composant opto-électronique selon l'une quelconque des revendications précédentes,
l'élément filtrant (5) contenant une matière en verre.

6. Composant opto-électronique selon l'une quelconque des revendications précédentes,
l'élément filtrant (5) étant disposé dans ou sur le boîtier (4) ou étant réalisé comme couvercle du boîtier (4).

7. Composant opto-électronique selon l'une quelconque des revendications précédentes,
l'écart entre l'élément filtrant (5) et le corps à semi-conducteur (1) étant supérieur à 0 µm et inférieur ou égal à 10 µm.

8. Composant opto-électronique selon l'une quelconque des revendications précédentes,
un élément de conversion étant disposé entre la zone active (2) et l'élément filtrant (5), lequel élément de conversion convertit le rayonnement généré par la zone active (2) en rayonnement d'autre longueur d'onde.

9. Composant opto-électronique selon l'une quelconque des revendications précédentes,
le composant présentant une pluralité de corps à semiconducteurs (1) ayant respectivement une zone active (2) destinée à générer un rayonnement électromagnétique, lesquels sont disposés sur un élément porteur commun.
